(19) Europäisches Patentamt
European Patent Office
Office européen des brevets

(11) Numéro de publication: **0 403 344 B1**

# (12) FASCICULE DE BREVET EUROPEEN

(45) Date de publication de fascicule du brevet: **12.10.94**

(51) Int. Cl.5: **G01R 27/02**, G01N 27/02, G01N 27/90

(21) Numéro de dépôt: **90401578.1**

(22) Date de dépôt: **08.06.90**

## (54) Appareil de mesure d'impédance surfacique.

(30) Priorité: **12.06.89 FR 8907726**

(43) Date de publication de la demande:
**19.12.90 Bulletin 90/51**

(45) Mention de la délivrance du brevet:
**12.10.94 Bulletin 94/41**

(84) Etats contractants désignés:
**BE CH DE ES GB GR IT LI SE**

(56) Documents cités:
**US-A- 3 848 183**
**US-A- 4 095 180**
**US-A- 4 351 031**
**US-A- 4 383 218**
**US-A- 4 383 218**

**IEE PROCEEDINGS, vol. 134, no. 3, partie A, mars 1987, pages 301-306,Stevenage, Herts, GB; D. RODGER et al.: "Three-dimensional finite-elementmodelling in eddy-current non-destructive testing"**

(73) Titulaire: **OFFICE NATIONAL D'ETUDES ET DE RECHERCHES AEROSPATIALES(O.N.E.R.A.)**
**Etablissement Public de l'Etat**
**29 avenue de la Divison Leclerc**
**F-92320 Châtillon (FR)**

Titulaire: **DASSAULT AVIATION**
**9, Rond Point des Champs Elysées Marcel Dassault**
**F-75008 Paris (FR)**

(72) Inventeur: **Gobin, Vincent**
**25, rue des Tournelles**
**F-92290 Chatenay Malabry (FR)**
Inventeur: **Labaune, Gérard**
**51 rue du Hameau des Joncherettes**
**F-91120 Palaiseau (FR)**
Inventeur: **Issac, François**
**1, rue Volant**
**F-92000 Nanterre (FR)**

(74) Mandataire: **Cabinet Martinet & Lapoux**
**BP 405**
**F-78055 Saint Ouentin en Yvelines Cédex (FR)**

EP 0 403 344 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

ELECTRONICS & COMMUNICATIONS IN JAPAN,vol. 63, no. 2, février 1980, pages 79-88, Scripta Publishing Co., SilverSpring, Maryland, US; F. HORIGUCHI et al.: "Contactless measurement of sheetconductivity and mobility of semiconductor wafer by using eddy current"

## Description

La présente invention concerne un appareil de mesure, dit impédancemètre, pour mesurer l'impédance surfacique d'un matériau.

En particulier, l'invention s'intéresse à des matériaux très bons conducteurs électriquement, présentés sous forme de plaque mince, tels que les métaux ou les matériaux composites conducteurs, par exemple à fibre de carbone, utilisés dans le matériel aéronautique. Ces matériaux peuvent éventuellement être recouverts de peintures ou revêtements isolants.

Il est rappelé que l'impédance surfacique $Z_s$ caractérisant de tels matériaux résulte de la définition suivante. Le matériau est parcouru par une densité de courant surfacique

$$\overrightarrow{J_s}$$

qui crée une différence de potentiel par unité de longueur représentée par le champ électrique longitudinal

$$\overrightarrow{E_{tg}}.$$

L'impédance $Z_s$ est définie par la relation :

$$\overrightarrow{E_{tg}} = Z_s \overrightarrow{J_s}$$

Dans le cas où le matériau est conducteur, l'impédance $Z_s$ est liée à la conductivité électrique $\sigma$ et l'épaisseur d du matériau par la relation $Z_s = 1/(\sigma d)$ tant qu'il n'y a pas apparition de l'effet de peau. Si on considère une plaque carrée d'impédance $Z_s$ parcourue par un courant I, il apparaît une différence de potentiel V aux bornes de la plaque telle que $V = Z_s I$.

La remarque ci-dessus peut être mise à profit pour mesurer l'impédance surfacique $Z_s$ de façon directe. Néanmoins, pour un matériau très bon conducteur, l'impédance du matériau se trouve en série avec l'impédance des fils qui injectent le courant I. Il n'est plus alors possible de distinguer la contribution du matériau et celle du circuit de mesure dans la mesure de la différence de potentiel V, qui devient alors impossible. Par ailleurs, une telle mesure ne peut être effectuée si le matériau est recouvert d'isolant.

Pour éviter cet inconvénient, il a déjà été proposé de mesurer l'impédance $Z_s$ sans contact électrique entre un impédancemètre et le matériau.

Un impédancemètre connu comprend, en outre, une première électrode, dite antenne d'émission, créant un champ électromagnétique déterminé, et une seconde électrode, dite antenne de réception. Une chaîne de mesure reliée à la seconde antenne permet de mesurer dans une bande de fréquence déterminée, le champ électromagnétique. Lors d'une première étape, l'antenne d'émission est placée à une distance constante prédéterminée de l'antenne de réception et est éloignée de tout matériau susceptible de perturber le champ émis directement par la première antenne et reçu par la seconde antenne. Au cours d'une seconde étape, un échantillon de matériau à tester est interposé entre les antennes d'émission et de réception. Au cours des deux étapes, une tension alternative vobulée dans une plage de fréquence prédéterminée est appliquée à l'antenne d'émission. Les mesures de tension aux bornes de l'antenne de réception pour les deux étapes sont analysées et interprétées pour déterminer la valeur de l'impédance surfacique $Z_s$ de l'échantillon de matériau.

Généralement, le matériau remplit une ouverture plane pratiquée dans un panneau métallique de grande dimension. Chacune des antennes est constituée par une boucle circulaire conductrice fixée sur une plaque porteuse isolante de part et d'autre du plan de l'ouverture.

L'antenne d'émission crée un champ magnétique uniforme au voisinage du matériau parallèlement au plan du matériau. Au cours de la première étape, l'antenne de réception reçoit un champ magnétique de l'autre côté de l'ouverture, à une distance donnée. Au cours de la seconde étape, l'antenne de réception reçoit un champ magnétique atténué par la présence du matériau dans l'ouverture.

Dans le cas d'une ouverture circulaire de rayon a, le rapport des tensions mesurées $V_0$ et V aux bornes de l'antenne de réception pendant les première et seconde étapes vérifie la relation approchée.

$$V/V_0 = 1/(1 + jf/f_c)$$

avec $f_c = (3Z_s/(8\mu_0 a))(1+2\pi R_c/Z_s))$
où $Z_s$ est l'impédance surfacique du matériau, a est le rayon de l'ouverture, $R_c$ est la résistance éventuelle du joint reliant le matériau et le panneau métallique, et $\mu_0 = 4\pi.10^{-7}$ H/m est la perméabilité magnétique du vide.

Si le contact électrique entre le matériau et le panneau métallique dans l'ouverture est parfait, c'est-à-dire si $R_c = 0$, on a $f_{co} = 3Z_s/8\mu_0 a$.

Ainsi la fixation du matériau dans l'ouverture provoque sur la tension captée par l'antenne de réception, une atténuation ou fonction de transfert de type "filtre passe-bas du premier ordre", caractérisée par une fréquence de coupure $f_{co}$ proportionnelle à l'impédance surfacique $Z_s$ du matériau.

L' impédancemètre connu à deux antennes complètement séparées et le procédé de mesure inhérent à cet appareil présentent principalement les trois inconvénients suivants :

i) L'expression de $f_c$ montre que si le contact matériau-panneau conducteur n'est pas parfait, la fréquence $f_c$ est décalée par rapport à $f_{co}$. Comme la valeur de $R_c$ ne peut pas être quantifiée, on doit réaliser un montage en tentant de minimiser la résistance parasite $R_c$. La valeur de celle-ci est alors négligée dans l'interprétation de la mesure, sans pouvoir estimer l'erreur commise. De plus, un échantillon de matériau recouvert de peinture ne peut être mesuré car le contact est mauvais.

ii) La fréquence $f_c$ dépend du rayon a de l'ouverture, c'est-à-dire de la dimension de l'échantillon de matériau testé. Par ce procédé ne peuvent être testés que des matériaux découpés à un format donné afin de les fixer dans l'ouverture. Il est donc nécessaire de réaliser un échantillon de chaque matériau à mesurer, et un matériau faisant partie d'une structure complexe ne peut être mesuré.

iii) La distance entre l'antenne d'émission et le matériau doit être suffisante pour obtenir un champ magnétique uniforme au voisinage du matériau. En conséquence, la distance entre les antennes est relativement grande et la tension mesurée par l'antenne de réception est relativement faible.

Le brevet US-A-4 383 218 décrit un système de mesure d'impédance dont la sonde, incluant une électrode d'excitation et une électrode de mesure enrobées dans un matériau diélectrique, est placée sur un même côté d'un matériau à tester lors de mesures. Une mesure d'impédance est réalisée par injection d'impulsion de courant dans l'électrode d'excitation et prélèvement d'une tension de mesure aux bornes de l'électrode de mesure.

Le brevet US-A-3 848 183 propose un système de mesure d'impédance dont la sonde se présente sous la forme de trois couronnes concentriques, dans chacune desquelles est ménagée une rainure circulaire dans laquelle est logé un enroulement. Un matériau à tester est placé au centre de ces trois couronnes. Un enroulement d'excitation est logé dans la rainure de la couronne intermédiaire, tandis que deux enroulements de mesure sont logés dans les rainures des couronnes intérieure et extérieure. Un déséquilibre entre les tensions mesurées au bornes des deux enroulements de mesure, en réponse à l'application d'une tension aux bornes de l'enroulement d'excitation, fournit des indications sur les caractéristiques du matériau à tester.

L'invention prévoit d'effectuer une mesure des caractéristiques du matériau à tester en utilisant des moyens pour produire une tension électrique vobulée en fréquence aux bornes d'une électrode d'excitation, ou première électrode.

A cette fin, un appareil pour mesurer l'impédance surfacique d'un matériau à tester est tel que défini dans la revendication 1.

D'autres caractéristiques de l'invention sont énoncées dans les revendications dépendantes.

D'autres avantages de la présente invention apparaîtront plus clairement à la lecture de la description suivante de plusieurs réalisations préférées de l'invention en référence aux dessins annexés correspondants dans lesquels :

- la Fig. 1 est une vue en perspective éclatée d'une première sonde à deux électrodes selon l'invention ;
- la Fig. 2 est un bloc-diagramme d'un impédancemètre selon l'invention, fonctionnant avec la sonde de la Fig. 1 ;
- les Figs 3 et 4 sont des diagrammes montrant des variations de rapport de tensions d'électrode, en fonction de la fréquence, particulièrement pour des sondes ayant des distances interélectrodes différentes, lorsque ces sondes sont appliquées contre un même matériau à tester ;
- les Figs 5 et 6 sont des diagrammes montrant des variations dudit rapport de tensions d'électrode en fonction de la fréquence, obtenues avec une même sonde et deux matériaux différents respectivement, et des courbes théoriques proches du type "filtre passe-bas" ;
- la Fig. 7 montre des courbes théoriques du type "filtre passe-bas" pour diverses valeurs d'impédance surfacique ;

- la Fig. 8 est un diagramme montrant des variations dudit rapport de tension en fonction de la fréquence, obtenues avec une même sonde et pour un même matériau, mais pour différentes distances de la sonde au matériau ;
- la Fig. 9 est une vue en perspective éclatée d'une seconde sonde comportant trois électrodes circulaires ;
- la Fig. 10 est un bloc-diagramme d'un impédancemètre fonctionnant avec la sonde de la Fig. 9 ;
- la Fig. 11 est une vue en perspective schématique de l'impédancemètre de la Fig. 10, sous la forme d'un appareil portable ; et
- la Fig. 12 est une vue en perspective éclatée d'une sonde comportant trois électrodes rectangulaires.

Une sonde de mesure SM pour impédancemètre selon l'invention et montrée à la Fig. 1 comprend une électrode d'injection 1 jouant le rôle d'antenne d'émission, et une électrode de mesure 2 jouant le rôle d'antenne de réception et disposée parallèlement à la première électrode 1. Chacune de ces électrodes 1, 2 est typiquement constituée par une spire circulaire imprimée sur l'une des faces d'une carte isolante 10, 20, ou par deux spires circulaires concentriques et imprimées sur les faces d'une carte imprimée double face. Cependant la seconde électrode peut être rectangulaire ou d'une forme quelconque. Les bornes voisines 11 et 12 , 21 et 22 de l'électrode 1, 2 sont constituées par des trous métallisés dans la carte 10, 20, à partir desquels peuvent s'étendre des conducteurs imprimés de liaison.

Selon la réalisation illustrée à la Fig. 1, les éléments 20, 3, 10 et 4 ont une même section carrée et sont maintenus empilés au moyen de quatre vis traversières et écrous 50 et 51. Les éléments ainsi empilés 20, 3, 10 et 4 sont ensuite enrobés dans une couche diélectrique mince de protection 52, telle que résine époxyde. Typiquement, si r désigne le rayon de l'électrode d'émission 1, le rayon de l'électrode de réception 2 est égal à r/2, et l'épaisseur z de la cale isolante 3 est égale à r.

Comme montré à la Fig. 2, pour effectuer des mesures d'impédance surfacique relatives à un matériau bon conducteur électrique à tester, on utilise comme échantillon, une plaque mince PM en ledit matériau. La sonde SM est disposée au-dessus de la plaque, de sorte que l'électrode de réception 2 soit en regard de la plaque, et que l'axe des électrodes 1 et 2 soit sensiblement perpendiculaires à la plaque PM. Dans ces conditions, l'électrode de réception 2 et la carte-support 20 de celle-ci sont à une distance h de la plaque de matériau PM qui peut pratiquement varier de 0, à la faible épaisseur de l'enrobage 52 près, à plusieurs millimètres. La distance interélectrode, sensiblement égale à l'épaisseur z de la cale 3, est par contre constante.

Par ailleurs, les électrodes 1 et 2 sont reliées à des circuits électroniques de l'impédancemètre IM proprement dit. Celui-ci est organisé autour d'une unité centrale de traitement (CPU) 6 comprenant un microprocesseur préprogrammé. L'unité 6 est reliée par un bus bidirectionnel interne BU à un générateur de fréquences 7 et à un analyseur vectoriel 8, et par un bus d'interface standard BIS à un dispositif d'affichage de résultat de mesure 9 qui comprend par exemple une imprimante.

Des sorties du générateur 7 sont reliées aux bornes 11 et 12 de l'électrode d'émission 1 à travers une charge d'adaptation d'impédance 13 qui est imprimée également sur la carte-support 10. Le générateur 7 produit un signal vobulé de tension alternative dont la fréquence f balaie périodiquement une gamme de fréquence $f_{min}$ et $f_{max}$ sélectionnée par l'unité de traitement 6. Le signal de tension produit par le générateur 7 se traduit par un courant électrique dans l'électrode d'émission 1 qui crée alors un courant induit dans la seconde électrode 2 et donc une tension induite aux bornes 21 et 22. Cette tension induite est égale à la dérivée temporelle du flux du champ magnétique qui traverse l'électrode de réception 2.

L'analyseur 8 a des entrées 81 et 82 reliées respectivement aux bornes de sortie 12 et 22 des électrodes 1 et 2 afin de mesurer la tension produite par le générateur 7 sur l'électrode 1 et la tension induite dans l'électrode 2, à chaque fréquence. Ces tensions sont lues sous forme numérique par l'unité 6.

La mesure de l'impédance surfacique $Z_s$ du matériau à tester est effectuée en deux étapes.

Au cours d'une première étape, la sonde SM est placée à une distance de tout matériau telle qu'aucun matériau ne puisse perturber le champ magnétique traversant directement l'électrode de réception 2. L'analyseur 8 mesure une tension $V_d(f)$ induite directement dans l'électrode 2. L'unité 6 mémorise chacune des valeurs de $V_d(f)$ en fonction de la fréquence f.

Au cours d'une seconde étape, la sonde SM est placée au-dessus du matériau PM, comme déjà décrit en référence à la Fig. 2, et est maintenue à une distance constante h n'excédant pas quelques millimètres. La distance h est de préférence la plus petite possible, c'est-à-dire est quasiment égale à zéro, comme on le verra dans la suite. L'analyseur 8 mesure une tension $V_m(f)$ induite dans l'électrode 2 par l'électrode 1. La tension $V_m$ résulte du flux magnétique produit par l'électrode 1 et perturbé par la plaque de matériau PM à proximité de l'électrode 2. L'unité 6 mémorise chacune des valeurs de $V_m(f)$ en fonction de la fréquence f, et calcule le rapport $S(f) = V_m/V_d$ inférieur à l'unité, exprimé sous la forme 20 log S(f), en vue de représenter ses variations en fonction de la fréquence f dans le dispositif d'affichage 9.

La tension mesurée sur l'électrode 1 permet de contrôler la stabilité du signal délivré par le générateur 7 lors des première et seconde étapes.

Théoriquement, on montre que le rapport de tension S est égal à la somme de deux coefficients S(f) = $S_1 + S_2(f)$ dont l'un $S_1$ est indépendant de la fréquence. Les coefficients $S_1$ et $S_2$ s'expriment en fonction des rapports z/r et h/r :

$$S_1 = 1 - \frac{(1+(z/r)^2)^{3/2}}{(1+(z/r+2h/r)^2)^{3/2}}$$

$$S_2 = (1+(z/r)^2)^{3/2}\int_0^{\infty}\frac{u^2}{(u+jf/f_{co})}J_1(u)e^{-u(z/r+2h/r)}$$

où $J_1(u)$ est la fonction de Bessel d'ordre 1, $f_{co}$ est une fréquence caractéristique telle que $f_{co} = Z_s/(\pi\mu_0 a)$, et $\mu_0 = 4\pi.10^{-7}$ H/m est la perméabilité magnétique du vide. Il apparaît que le coefficient $S_1$ ne dépend que des paramètres géométriques z/r et h/r et est indépendant de la fréquence de mesure f, et que le coefficient $S_2$ dépend de z/r, h/r, $f_{co}$ et de la fréquence f.

La fonction S(f) est maintenant analysée principalement en fonction de la distance h entre la sonde SM et le matériau PM afin de présenter les avantages du choix h ≈0 lors de l'utilisation de l'impédancemètre.

Dans le cas où h = 0, la sonde SM est appliquée directement contre le matériau PM. Le coefficient $S_1$, est alors égal à 0 et le rapport de tension S se réduit à :

$$S = S_2 = [1+(z/r)^2]^{3/2}\int_0^{\infty}\frac{u^2}{u+jf/f_{co}}J_1(u)e^{-u(z/r)}du$$

Le rapport S ne dépend que du paramètre géométrique z/r, de la fréquence caractéristique $f_{co}$ qui est proportionnelle à l'impédance surfacique $Z_s$ du matériau, et de la fréquence de mesure f. La fonction S peut alors être calculée numériquement.

Les Figs. 3 et 4 montrent la variation de S exprimée en dB en fonction de $\log(f/f_{co})$ pour plusieurs valeurs de z/r égales à 0,00 ; 0,1 ; 0,25 ; 0,5 ; 1,0 ; 10,0 ; 100,0 et 1000,0.

Le rapport S varie comme une fonction de type passe-bas dont la forme et particulièrement la pente aux fréquences élevées, dépendent de z/r. Ainsi, pour une géométrie de la sonde SM déterminée par des paramètres constants, la position de la courbe de variation de S par rapport à l'axe des fréquences est directement liée à $Z_s$. Lors de la mesure, comme on le verra dans la suite, l'unité de traitement 6 recherche l'une de courbes théoriques de type passe-bas s'approchant le plus de la courbe de variation de S correspondant au matériau à tester et obtenue par la mesure proprement dite, et identifie la position de la courbe de variation de S en fonction de la fréquence f dans la gamme $[f_{min}, f_{max}]$ par un ou plusieurs points caractéristiques, par exemple à 3 dB, 10, 20 et 30 dB, pour déterminer $Z_s$.

Pour z/r variant de 0 à 1 selon la Fig. 3, la forme de la courbe de variation de S passe progressivement d'une courbe du deuxième ordre à 40 dB/décade environ, à une courbe du premier ordre à 20 dB/décade environ, la fréquence de coupure généralement choisie à 3 dB variant peu. Pour z/r variant au-delà de 1 selon la Fig. 4, la fonction S est peu différente d'une fonction passe-bas du premier ordre, la fréquence de coupure à 3 dB se déplaçant vers les basses fréquences.

Ainsi, bien que n'importe quelle valeur de z/r convienne pour mesurer l'impédance surfacique $Z_s$, l'invention recommande de choisir le paramètre géométrique z/r et donc la géométrie de la sonde selon les deux critères suivants.

La tension induite aux bornes 21 et 22 de la deuxième électrode 2 est proportionnelle à la dérivée temporelle du flux magnétique qui la traverse et donc à la fréquence f. Pour élargir la mesure vers les basses fréquences, il faut que le flux et donc la tension induite soient suffisants ce qui implique un bon couplage entre les électrodes 1 et 2 et une distance interélectrode z assez petite.

Pour déterminer l'impédance $Z_s$, l'unité 6 repère la position de la courbe de variation de S mesurée par rapport à au moins une droite déterminée parallèle à l'axe des fréquences puisque, pour une valeur donnée de S, il n'existe qu'une seule valeur de $Z_s$ et donc de $f_{co}$, correspondant à un rapport $f/f_{co}$. Il est donc préférable que l'unité 6 identifie une courbe "simple". Selon l'invention, l'unité 6 recherche par approximations successives une fonction passe-bas du premier ordre la plus voisine de la fonction S(f) obtenue lors de la mesure. Par exemple, le cas particulier z/r = 1 convient bien les Figs 5 et 6 montrent que la fonction S(f) obtenue après mesure est peu différente de la fonction $FBP = (1 + (f/f_c)2)^{-1/2}$
où $fc \approx 1{,}4\ f_{co} = 1{,}4\ Z_s/(\pi\mu_0 r)$

La Fig. 7 représente différentes courbes FBP(f) pour diverses valeurs de $Z_s$ et montre que plus l'impédance $Z_s$ est petite, plus les mesures sont effectués dans les basses fréquences.

Ainsi, pour déterminer l'impédance $Z_s$ d'un matériau avec une sonde SM telle que z = r, l'unité 6 identifie la courbe S(f) pour plusieurs valeurs prédéterminées de S ou de f, calcule l'écart-type entre la courbe S(f) et diverses fonctions FBP(f) correspondant à des valeurs de $f_c$, et ne retient que la fonction FBP offrant l'écart-type le plus petit. Puis de la fonction retenue $FBP_c$ et donc de la fréquence caractéristique correspondante $f_c$ est alors déduite l'impédance du matériau $Z_s = \pi\mu_0\ r\ f_c/1{,}4$.

Dans le cas où h≠0 c'est-à-dire où la sonde SM n'est pas appliquée sur la plaque de matériau PM, le coefficient $S_1$ n'est plus nul mais est égal à une constante, pour une géométrie donnée et une position prédéterminée de la sonde SM, c'est-a-dire pour z/r et h/r constants. Le second coefficient $S_2$ est toujours une fonction de type passe-bas qui tend vers 0 quand f tend vers l'infini. Le rapport $S = S_1 + S_2$ est donc approximativement égal à $S_2$ en basse fréquence et à $S_1$ en haute fréquence.

La Fig. 8 représente la fonction de filtrage S en fonction de la fréquence f pour plusieurs valeurs de la distance h entre la sonde SM et le matériau PM, lorsque la distance interélectrode est constante et égale à z = r. Le début en basse fréquence des courbes dans la Fig. 6 est peu différent du cas h = 0 selon les Figs. 4 et 5. En haute fréquence, les courbes de la Fig. 8 tendent vers des paliers respectifs égaux à $S_1$(h/r).

Si on cherche à déterminer l'impédance surfacique $Z_s$, h doit être le plus petit possible puisqu'une dynamique importante est recherchée pour identifier la forme de la courbe S(f) obtenue lors de la mesure.

Par contre, la valeur du maximum d'atténuation $S_1$ ne dépend que de h pour z/r constant et est indépendante de l'impédance du matériau. La courbe $S_1$(h) peut être utilisée pour déterminer expérimentalement la distance entre la sonde et un matériau conducteur, cette distance étant par exemple égale à l'épaisseur d'un revêtement isolant recouvrant le matériau.

Le procédé de mesure mis en oeuvre par l'impédancemètre permet d'évaluer l'impédance surfacique $Z_s$ d'un matériau conducteur. Toutefois, pour un matériau homogène, à partir de la formule $Z_s = 1/(\sigma\ d)$,

- si $\sigma$ est connu, l'épaisseur du matériau $d = 1/(Z_s\ \sigma)$ est déduite, et
- si d est connu, la conductivité du matériau $\sigma = 1/(Z_s d)$ est déduite.

Afin de fixer les idées, par exemple une sonde SM pour laquelle z≈r = 5cm, impose une fréquence caractéristique

$$f_c \approx 1{,}4\ Z_s/(\pi\mu_0\ r) \approx 2.10^7\ Z_s$$

En supposant un balayage en fréquence de 0 jusqu'à une fréquence maximale prédéterminée $f_{max}$, l'impédance surfacique mesurée sera inférieure à $Z_{s\ max} = f_{max}/(2.10^7)$, soit par exemple $Z_{s\ max} = 0{,}5\ \Omega$ pour $e_{max} = 10$ MHz, et $Z_{s\ max} = 5\ \Omega$ pour $f_{max} = 100$ MHz.

Ainsi l'impédancemètre avec la sonde selon cet exemple mesure des impédances surfaciques inférieures à quelques ohms.

Il est à noter que plus l'impédance mesurée est faible, plus la mesure doit être effectuée en basse fréquence, selon la Fig. 7. Comme déjà dit, la tension mesurée par l'intermédiaire de l'électrode de réception 2 est proportionnelle au produit du flux qui la traverse par la fréquence. Il faut donc augmenter le flux émis par la première électrode 1 pour effectuer des mesures en basses fréquences. L'antenne d'émission n'est plus composée d'une seule spire mais d'un enroulement de n spires, et la sensibilité de la sonde est alors augmentée du facteur entier n. Dans ce cas, la carte 10 supporte sur une ou les deux faces plusieurs spires concentriques, ou est remplacée par un circuit multicouche, chaque couche comportant au moins une spire. Selon une autre variante qui peut être mise en oeuvre seule ou en combinaison avec la solution précédente, un amplificateur est prévu en sortie du générateur de fréquences 7 pour amplifier le courant dans l'électrode d'émission 1 et le flux magnétique et par suite, la sensibilité de la sonde SM.

Le procédé de mesure décrit ci-dessus et mis en oeuvre par l'impédancemètre IM muni de la sonde selon la Fig. 2 consiste en deux étapes successives : un étalonnage de la sonde éloignée de tout matériau au cours de la première étape, puis une mesure de l'impédance surfacique en appliquant la sonde SM sur le matériau PM au cours de la seconde étape.

Pour accroître la rapidité des mesures, l'étape d'étalonnage est effectuée simultanément avec l'étape de mesure, à chaque valeur de fréquence, en utilisant une sonde SMa ayant une antenne d'émission 1 et deux antennes de réception 2a et 2R, et un impédancemètre IMa correspondant.

En référence à la Fig. 9, la sonde SMa comprend, comme la sonde SM, les éléments empilés suivants, savoir une carte imprimée 20a supportant une électrode de réception de préférence circulaire 2a, une cale isolante 3a, une carte imprimée 10a supportant une électrode d'émission circulaire 1a, et un capot isolant 4a. En outre, entre la carte 10a et le capot 4a, la sonde SMa comporte une seconde cale isolante 3R, et une troisième carte imprimée 20R supportant une électrode de référence 2R de préférence circulaire. La carte 20R est interposée entre le capot 4a et la cale 3R. La cale 3R est appliquée contre la carte 10a. Tous les éléments de la sonde SMa ont une même section, ici carrée ou bien discoïde par exemple, et sont serrés les uns sur les autres au moyen de quatre paires de vis 50a et écrou 51a. Puis l'ensemble des éléments empilés de la sonde SMa est enrobé dans de la résine 52a. Par exemple, la cale 3R et la carte 20R sont respectivement identiques à la cale 3a et la carte 20a, et le rayon de l'électrode de référence est égal à r/2.

La troisième électrode 2R dans la sonde SMa joue le même rôle que l'antenne de réception 2 dans la sonde SM au cours de la première étape du procédé de mesure. En effet, lorsque la face de la sonde SMa qui comporte l'électrode 2a est appliquée sur une plaque de matériau PM, l'électrode de référence 2R est située à l'opposé de la plaque PM par rapport à la carte médiane 10a supportant l'électrode d'émission 1a. La distance entre l'électrode 2R et la plaque PM est alors suffisamment élevée pour que la plaque PM ne perturbe pas le flux magnétique émis par l'électrode 1a et générant la tension induite à des bornes 21R et 22R de l'électrode 2R.

Comme montré aux Figs. 10 et 11, l'impédancemètre IMa comprend également une unité centrale de traitement 6a à microprocesseur intégré, un générateur sinusoïdal de fréquences 7a, et des moyens de commande et d'affichage 9a.

L'analyseur vectoriel 8 est remplacé dans l'impédancemètre IMa par trois ensembles parallèles comprenant chacun en série un amplificateur d'entrée 711, 712, 71R, un limiteur de tension 721, 722, 72R, et un convertisseur analogique-numérique 731, 732 et 73R. Les sorties du générateur 7a sont reliées aux bornes 11a et 12a de l'électrode d'émission 1a et aux bornes d'entrée de l'amplificateur 711. Les bornes 21a et 22a de l'antenne de réception et de mesure 2a et les bornes 21R et 22R de l'antenne de réception et de référence 2R sont respectivement reliées aux bornes d'entrée des amplificateurs 712 et 71R. Dans ces conditions, lorsque l'unité 6a ordonne un balayage en fréquence dans une gamme déterminée $f_{min}$ à $f_{max}$, les convertisseurs 731, 732 et 73R transmettent sous forme numérique simultanément une tension $V_1$-(f) appliquée aux bornes de l'électrode d'émission 1a par le générateur 7a, une tension $V_2$(f) induite dans l'électrode 2a dépendante de l'impédance $Z_s$ du matériau PM, et une tension de référence $V_R$(f) induite dans l'électrode 73R. Pour chaque fréquence f, l'unité 6a calcule directement le support S(f) = $V_2/V_R$ ce qui permet de visualiser rapidement la courbe S(f) avec la courbe approchante $FBF_c$ sur l'écran 9Sf, et d'afficher la valeur numérique $Z_s$ du matériau PM dans un afficheur 9Z. Préalablement à la mesure, l'opérateur sélectionne une bande de fréquence [$f_{min}$, $f_{max}$] et donc la gamme d'impédance $Z_s$ au moyen d'un sélecteur 9SE, et le type de sonde au moyen d'un bouton 9SO.

L'impédancemètre IMa comprend également une interface standard IN à bus bidirectionnel de télécommunications du type RS 232C pour échanger des signaux numériques avec un calculateur éloigné stockant des courbes et résultats obtenus.

Les impédancemètres décrits ci-dessus s'appliquent aus matériaux représentables par une impédance surfacique isotrope. Les mesures sont alors interprétées quantitativement.

Dans le cas d'un matériau fortement anisotrope, tel qu'un composite de carbone à fibres parallèles, l'impédance surfacique est composée d'une impédance $Z_{sx}$ suivant une direction x et d'une impédance $Z_{sy}$ suivant une direction y perpendiculaire à la direction x. Selon l'invention, les électrodes circulaires 1 et 2 dans la sonde SM, ou les électrodes 1a, 2a et 2R dans la sonde SMa sont remplacées par des électrodes à boucles rectangulaires 1'a, 2'a et 2'R, comme montré à la Fig. 12 pour une sonde SM'a. Dans cette Fig. 12, des éléments analogues à ceux montrés à la Fig. 9 sont désignés par des mêmes indices, mais accentués. Chaque électrode rectangulaire est ainsi constituée d'au moins deux brins conducteurs longitudinaux reliés à l'une de leurs extrémités par un coude conducteur et ayant une longueur au moins égale à 10 fois la distance très petite entre ces brins, de l'ordre de quelques millimètres. Les deux ou trois électrodes internes dans la sonde s'étendent suivant la même direction longitudinale x, comme montré à la Fig. 12.

Si l'on applique cette sonde à électrodes rectangulaires suivant les deux directions perpendiculaires x et y sur le matériau anisotrope, l'impédancemètre affiche deux courbes différentes $S_x$(f) et $S_y$(f) qui permettent de déduire les valeurs de $Z_{sx}$ et $Z_{sy}$ pour le matériau considéré. L'une de ces deux courbes présentant la plus forte atténuation correspond au cas où la direction longitudinale commune x des électrodes de la sonde est parallèle au sens des fibres, c'est-à-dire à la direction suivant laquelle la conductivité du matériau est la meilleure.

Une sonde selon l'invention est en outre capable de déceler toute discontinuité dans un matériau qui, par nature, modifie la répartition du champ magnétique générateur du courant induit dans l'électrode de réception. Par exemple, si la sonde est appliquée sur une fente existant entre deux plaques constituées d'un même matériau, la mesure fournie par l'impédancemètre varie considérablement et signale la présence de la fente. Ce phénomène est accentué si l'on choisit d'utiliser une sonde ayant une électrode de réception à boucle rectangulaire placée sur la fente.

D'autres discontinuités de matériau peuvent être détectées, telles que des jonctions entre deux plaques en un même matériau. Si le contact entre ces plaques est électriquement parfait, la mesure d'impédance effectuée en plaçant une sonde sur une jonction des plaques doit être identique à celle sur une plaque uniforme en ce matériau ; si le contact électrique à la jonction est défectueux, la mesure est analogue à celle d'une fente. Un étalonnage permet d'évaluer l'état du contact électrique.

## Revendications

**1.** Appareil pour mesurer l'impédance surfacique ($Z_s$) d'un matériau à tester (PM), comprenant

une première électrode (1) produisant un champ magnétique au voisinage dudit matériau,

une seconde électrode (2) recevant le champ magnétique, et

lesdites première et seconde électrodes (1, 2) étant superposées par l'intermédiaire d'un matériau diélectrique (3, 52) en une sonde compacte (SM) à appliquer à proximité d'un même côté dudit matériau à tester,

des moyens (7) pour produire une tension électrique vobulée en fréquence aux bornes (11, 12) de la première électrode,

des moyens de mesure (8) pour mesurer une tension vobulée aux bornes de la seconde électrode (2),

caractérisé par

des moyens de calcul (6) pour calculer la variation du rapport entre des secondes tensions (Vd, Vm) mesurées aux bornes de la seconde électrode (2) en fonction de la fréquence lorsque la sonde (SM) est éloignée dudit matériau à tester puis lorsque la sonde (SM) est disposée d'un même côté dudit matériau à tester (PM) afin d'en déduire l'impédance surfacique ($Z_s$) du matériau à tester, et

la sonde (SM) comprenant une première cale en matériau diélectrique (3), et deux cartes minces (10, 20) en matériau diélectrique qui sont respectivement fixées mécaniquement sur deux faces parallèles de ladite première cale (3), et sur lesquelles sont imprimées les première et seconde électrodes (1, 2) respectivement.

**2.** Appareil de mesure conforme à la revendication 1, caractérisé en ce que la sonde (SM) comporte un enrobage diélectrique externe (52) au moins sur l'une des deux cartes minces sur laquelle est imprimée la seconde électrode (2) afin d'appliquer ladite sonde contre le matériau (PM).

**3.** Appareil conforme à la revendication 1 ou 2, caractérisé en ce que la sonde (SMa) comprend une troisième électrode (2R) imprimée sur une carte mince supplémentaire et recevant ledit champ magnétique, ladite carte étant superposée à la carte sur laquelle est imprimée la première électrode par l'intermédiaire d'une seconde cale en matériau diélectrique (3'R), à l'opposé de la seconde électrode (2a), et en ce que les moyens de mesure mesurent en outre une troisième tension aux bornes de la troisième électrode (2R).

**4.** Appareil conforme à la revendication 3, caractérisé en ce que les seconde et troisième électrodes (2a, 2R) sont symétriques par rapport à la première électrode (1a) dans la sonde (SMa).

**5.** Appareil conforme à la revendication 3 ou 4, caractérisé en ce que les moyens de calcul (6, 6a) calculent la variation du rapport entre les troisième et seconde tensions en fonction de la fréquence lorsque la sonde (SMa) est disposée d'un même côté dudit matériau et ladite seconde électrode (2a) est l'électrode la plus proche dudit matériau, afin d'en déduire l'impédance surfacique ($Z_s$) dudit matériau (PM) en recherchant, parmi des courbes de référence du type passe-bas (FPB) préenregistrées, la courbe de référence la plus proche de la variation dudit rapport entre les tensions ($V_2/V_R$).

**6.** Appareil conforme à l'une quelconque des revendications 1 à 5, caractérisé en ce qu'au moins l'une (1 ; 1a) des électrodes est une boucle circulaire.

**7.** Appareil conforme à l'une quelconque des revendications 1 à 6, caractérise en ce qu'au moins l'une (2'a ; 2'R) des électrodes est une boucle rectangulaire, de préférence avec une longueur égale à environ au moins dix fois la largeur de l'électrode.

8. Appareil conforme à l'une quelconque des revendications 1 à 7, caractérisé en ce qu'au moins l'une (1 ; 1a) des électrodes est constituée par plusieurs spires concentriques et/ou superposées.

**Claims**

1. Device for measuring the surface impedance ($Z_s$) of a material to be tested (PM) comprising
   a first electrode (1) producing a magnetic field in the area surrounding said material,
   a second electrode (2) receiving the magnetic field, and
   said first and second electrodes (1,2) being superposed by the intermediary of a dielectric material (3, 52) into a compact probe (SM) to be applied near a same side of said material to be tested,
   means (7) for producing an electrical voltage wobbled in frequency to the terminals (11,12) of the first electrode,
   measuring means (8) for measuring a wobbled voltage at the terminals of the second electrode (2),
   characterized by
   computing means (6) for computing the variation of the ratio between second voltages (Vd, Vm) measured at the terminals of the second electrode (2) as a function of the frequency when the probe (SM) is moved away from said material to be tested, then when the probe (SM) is placed on a same side of said material to be tested (PM) thereby deducting the surface impedance ($Z_s$) of the material to be tested, and
   the probe (SM) comprising a first wedge of dielectric material (3), and two thin boards (10, 20) of dielectric material that are respectively fixed mechanically on two parallel sides of said first wedge (3) and on which are printed the first and second electrodes (1,2), respectively.

2. Measuring device according to claim 1, characterized in that the probe (SM) comprises an exterior dielectric coating (52) on at least one of the two thin boards on which is printed the second electrode (2) so as to apply said probe against the material (PM).

3. Device according to claim 1 or 2, characterized in that the probe (SMa) comprises a third electrode (2R) printed on a supplemental thin board and receving said magnetic field, said board being superposed with the board on which the first electrode is printed by the intermediary of a second wedge of dielectric material (3'R), opposed to the second electrode (2a), and in that the measuring means further measure a third voltage at the terminals of the third electrode (2R).

4. Device according to claim 3, characterized in that the second and third electrodes (2a, 2R) are symmetrical with regard to the first electrode (1a) in the probe (SMa).

5. Device according to claim 3 or 4, characterized in that the computing means (6, 6a) compute the variation of the ratio between the third and second voltages as a function of the frequency when the probe (SMa) is placed on a same side of said material and said second electrode (2a) is the electrode nearest said material, in order to deduct the surface impedance ($Z_s$) of said material (PM) by seeking out, among stored reference curves of the low-pass type (FPB), the reference curve nearest the variation of said ratio between the voltages ($V_2/V_R$).

6. Device according to any one of claims 1 to 5, characterized in that at least one (1 , 1a) of the electrodes is a circular loop.

7. Device according to any one of claims 1 to 6, characterized in that at least one (2'a ; 2'R) of the electrodes is a rectangular loop, preferably with a length equal to approximately at least ten times the width of the electrode.

8. Device according to any one of claims 1 to 7, characterized in that at least one (1 ;1a) of the electrodes is comprised of several concentric and/or superposed spires.

**Patentansprüche**

1. Meßanordnung für einen Oberflächenwiderstand ($Z_S$) eines zu testenden Materials (PM), mit einer ersten Elektrode (1), die ein Magnetfeld in der Nähe des Materials erzeugt, einer zweiten Elektrode (2), die das Magnetfeld empfängt, wobei die erste und zweite Elektrode (1, 2) durch ein Zwischenstück aus einem dielektrischen Material (3, 52) getrennt in einer kompakten Sonde (SM) übereinanderliegen, die in die Nähe einer gleichen Seite des zu testenden Materials gebracht wird, Einrichtungen (7) zur Erzeugung einer gewobbelten elektrischen Spannung an den Anschlüssen (11, 12) der ersten Elektrode (1) und Meßeinrichtungen zur Messung einer gewobbelten Spannung an den Anschlüssen der zweiten Elektrode (2), gekennzeichnet durch Recheneinrichtungen (6) zur Berechnung der Variation des Verhältnisses zwischen den beiden Spannungen (Vd, Vm), die an den Anschlüssen der zweiten Elektrode (2) als Funktion der Frequenz gemessen werden, wenn die Sonde (SM) von dem zu testenden Material entfernt wird, und danach, wenn die Sonde (SM) auf einer gleichen Seite des zu testenden Materials (PM) angeordnet wird, um daraus den Oberflächenwiderstand ($Z_S$) des zu testenden Materials abzuleiten, und durch die Sonde (SM), die ein erstes Zwischenstück aus dielektrischem Material (3) und zwei dünne Karten (10, 20) aus dielektrischem Material aufweist, die jeweils mechanisch auf zwei parallelen Seiten des ersten Zwischenstücks (3) angeordnet sind, und auf die erste und zweite Elektroden (1, 2) aufgedruckt sind.

**2.** Meßanordnung nach Anspruch 1, dadurch gekennzeichnet, daß die Sonde (SM) mindestens auf einer der dünnen Karten, auf der die zweite Elektrode (2) aufgedruckt ist, eine äußere dielektrische Hülle (52) aufweist, um diese Sonde gegen das Material (PM) zu richten.

**3.** Meßanordnung nach Anspruch 1 oder 2, dadurch gekennzeichnet, daß die Sonde (SMa) eine dritte Elektrode (2R) aufweist, die auf eine dünne zusätzliche Karte aufgedruckt ist und das Magnetfeld empfängt, wobei diese Karte über der Karte mit der aufgedruckten ersten Elektrode durch ein zweites Zwischenstück aus dielektrischem Material (3'R) getrennt und auf der anderen Seite der zweiten Elektrode (2a) liegt, und dadurch, daß die Meßeinrichtungen außerdem eine dritte Spannung an den Anschlüssen der dritten Elektrode (2R) messen.

**4.** Anordnung nach Anspruch 3, dadurch gekennzeichnet, daß die zweite und dritte Elektrode (2a, 2R) symmetrisch zur ersten Elektrode (1a) in der Sonde (SMa) angeordnet sind.

**5.** Anordnung nach Anspruch 3 oder 4, dadurch gekennzeichnet, daß die Recheneinrichtungen (6, 6a) die Variation des Verhältnisses zwischen der dritten und zweiten Spannung als Funktion der Frequenz berechnen, wenn die Sonde (SMa) auf einer gleichen Seite des Materials angeordnet ist und die zweite Elektrode (2a) die dem Material am nächsten liegende Elektrode ist, um daraus den Oberflächenwiderstand ($Z_S$) des Materials (PM) abzuleiten, indem zwischen vorab abgespeicherten Tiefpaß-Referenzkurven (FPB) die der Variation des Verhältnisses zwischen den Spannungen ($V_2/V_R$) am nächsten liegende Referenzkurve herausgesucht wird.

**6.** Anordnung nach einem der Ansprüche 1 bis 5, dadurch gekennzeichnet, daß mindestens eine (1, 1a) der Elektroden eine kreisförmige Schleife ist.

**7.** Anordnung nach einem der Ansprüche 1 bis 6, dadurch gekennzeichnet, daß mindestens eine (2'a; 2'R) der Elektroden eine rechteckige Schleife ist, vorzugsweise mit einer Länge, die ungefähr dem Zehnfachen der Breite der Elektrode entspricht.

**8.** Anordnung nach einem der Ansprüche 1 bis 7, dadurch gekennzeichnet, daß mindestens eine (1; 1a) der Elektroden von mehreren konzentrischen und/oder übereinanderliegenden Windungen gebildet ist.

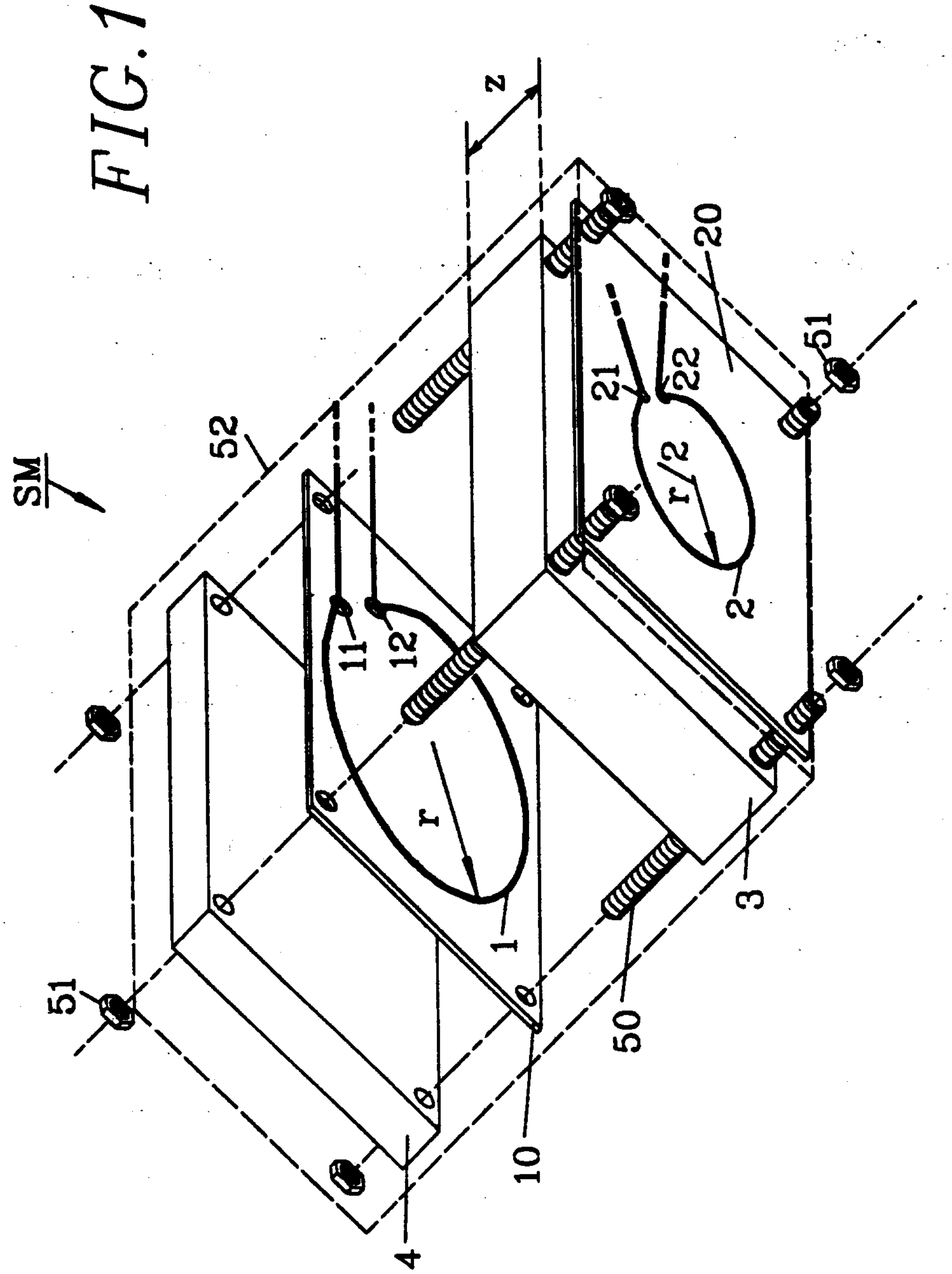


FIG. 1

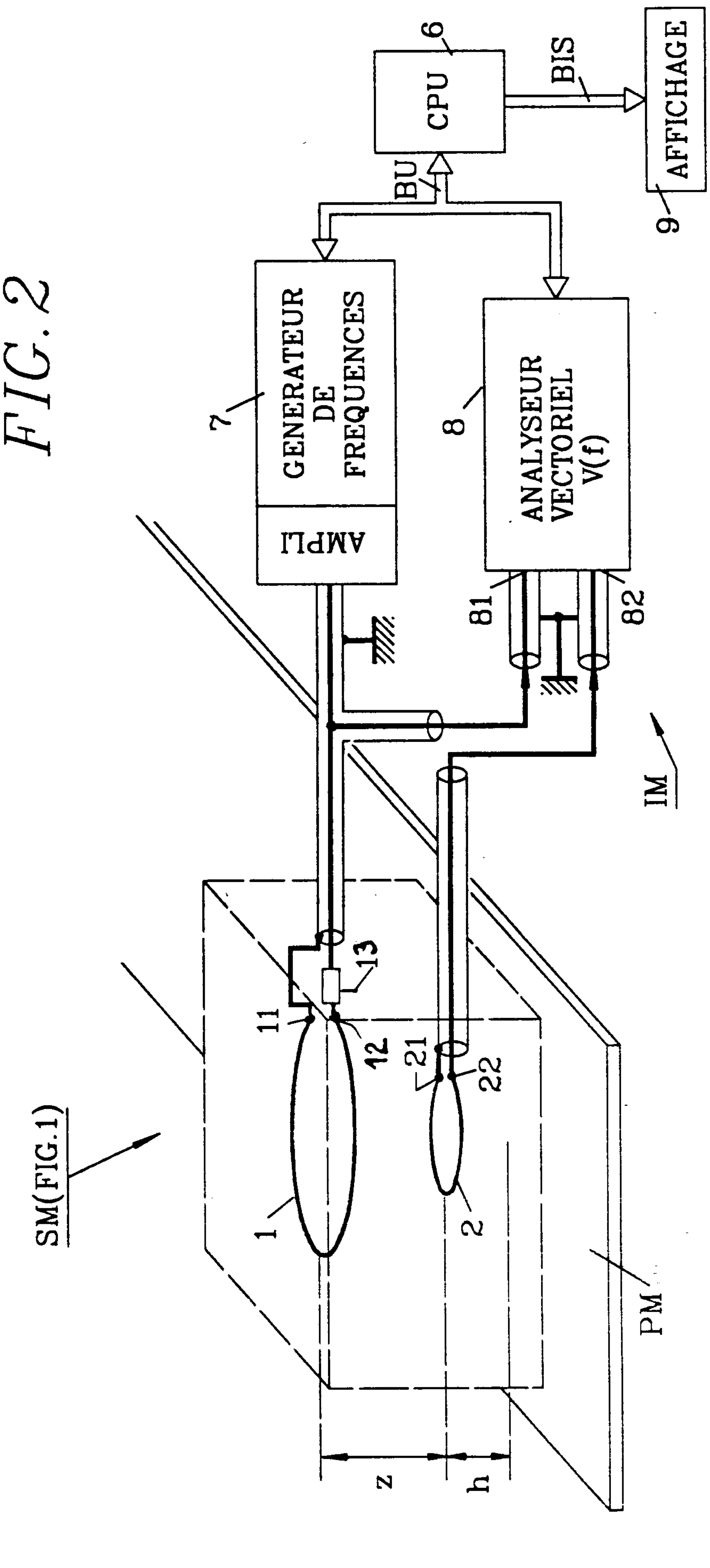

CPU
6
BIS
AFFICHAGE
9
BU
GENERATEUR DE FREQUENCES
AMPLI
7
ANALYSEUR VECTORIEL V(f)
8
81
82
IM
SM(FIG.1)
1
2
11
12
13
21
22
PM
z
h


FIG. 2

FIG. 3

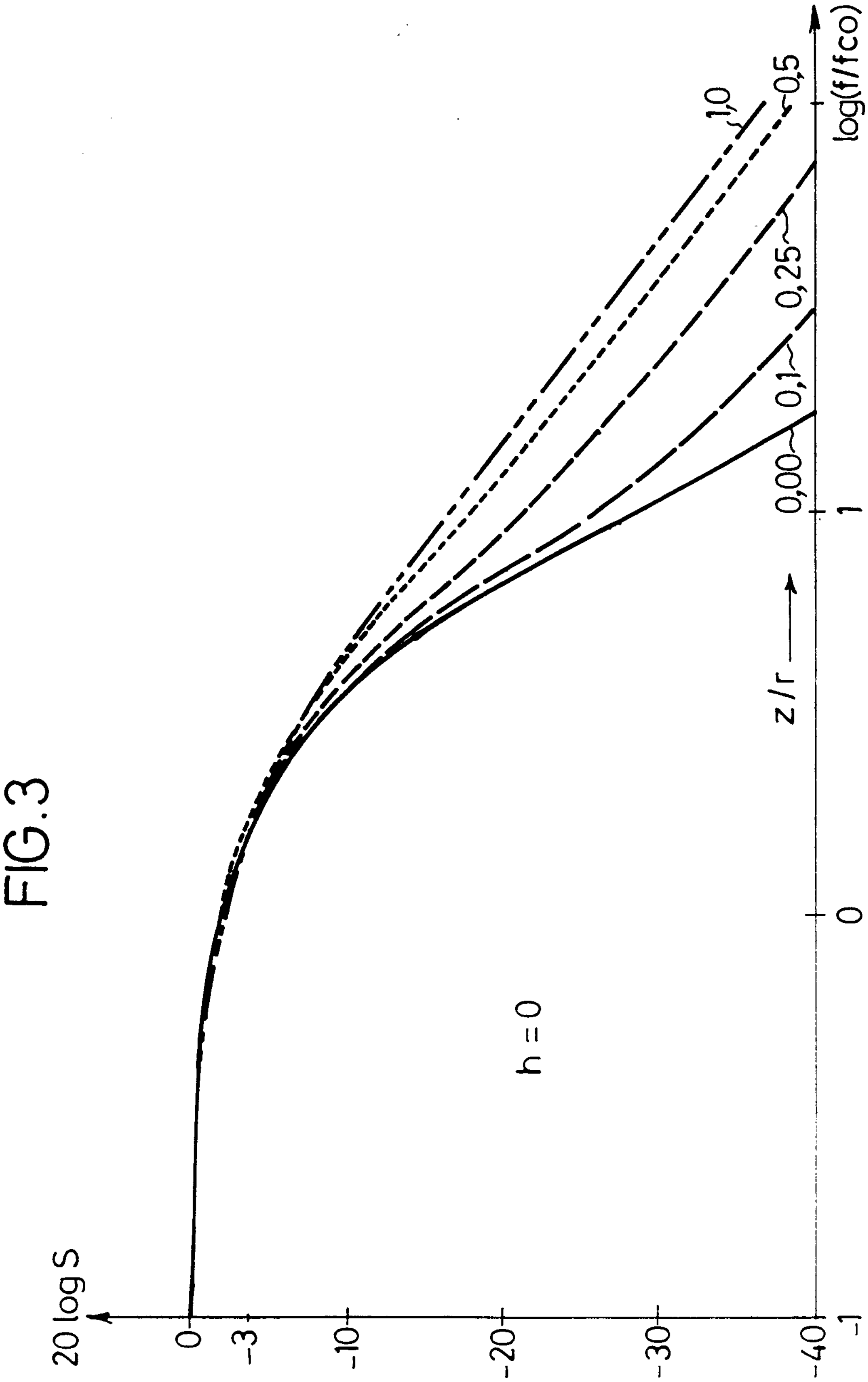

FIG. 4

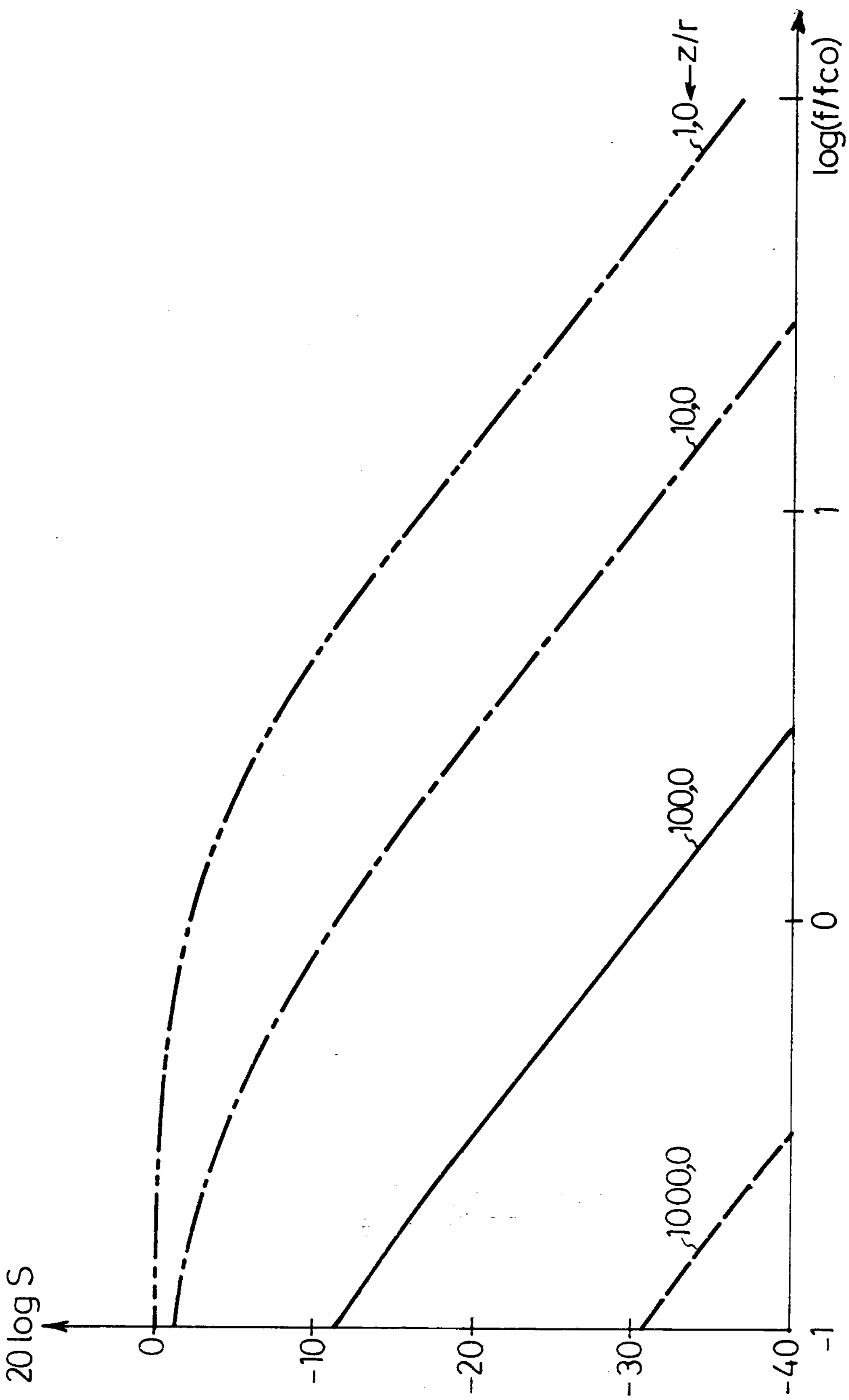

FIG.5

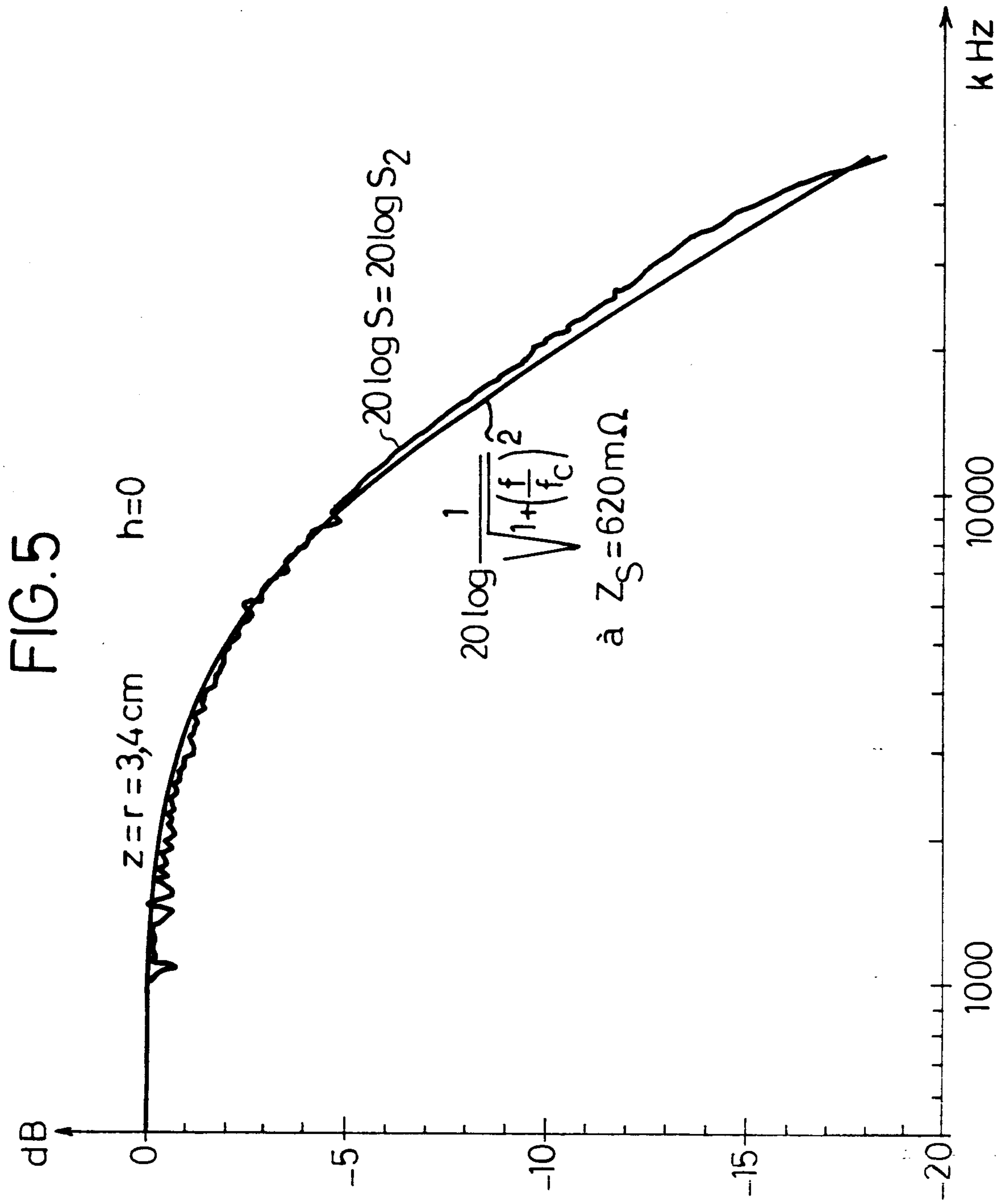
dB
0
-5
-10
-15
-20
1000
10000
k Hz
z = r = 3,4 cm
h=0
20 log S = 20 log S2
20 log 1/√(1+(f/fc)²)
à Zs = 620 mΩ

FIG.6

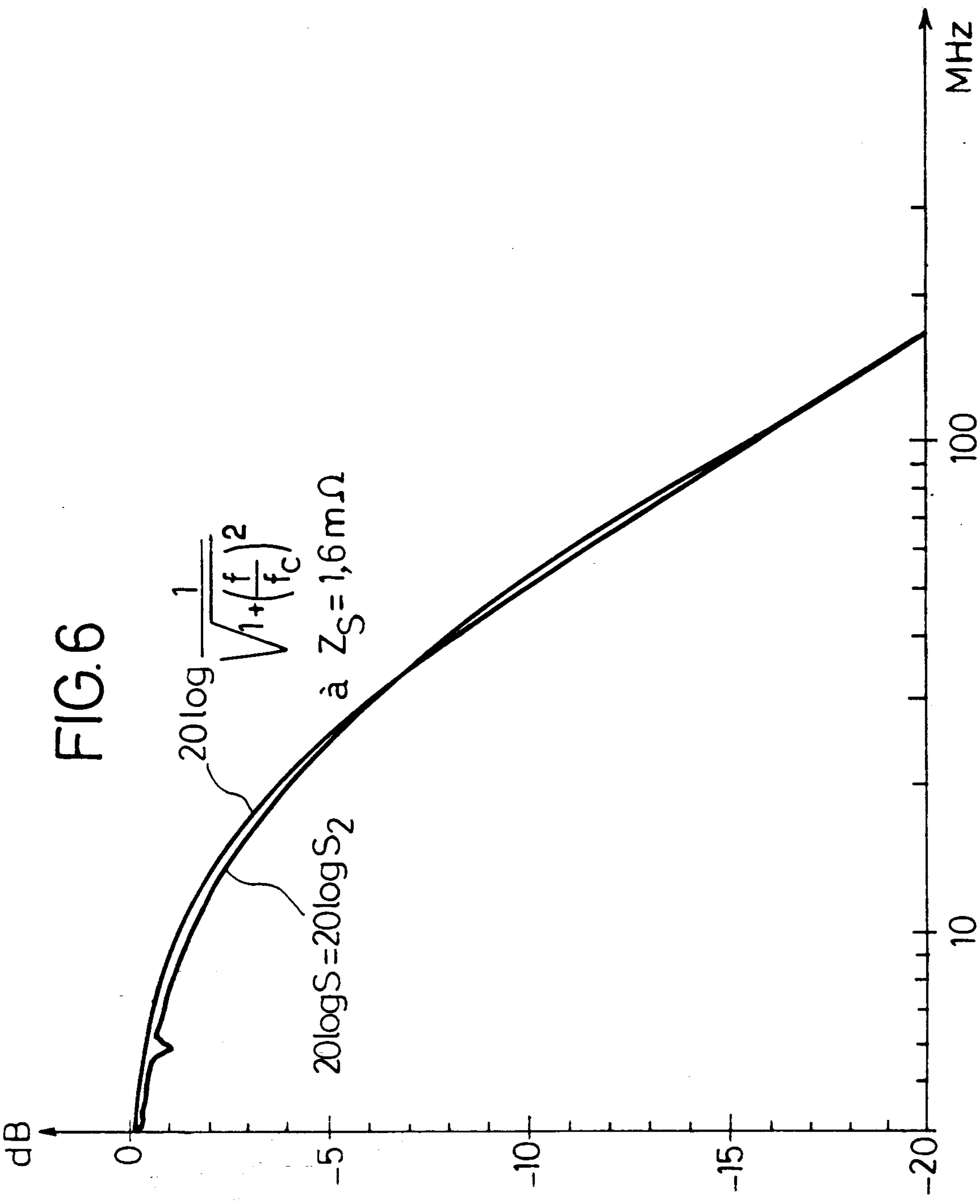
dB
0
-5
-10
-15
-20
10
100
MHz
$20\log\frac{1}{\sqrt{1+\left(\frac{f}{f_c}\right)^2}}$
à $Z_S = 1,6\,m\Omega$
$20\log S = 20\log S_2$

FIG.7

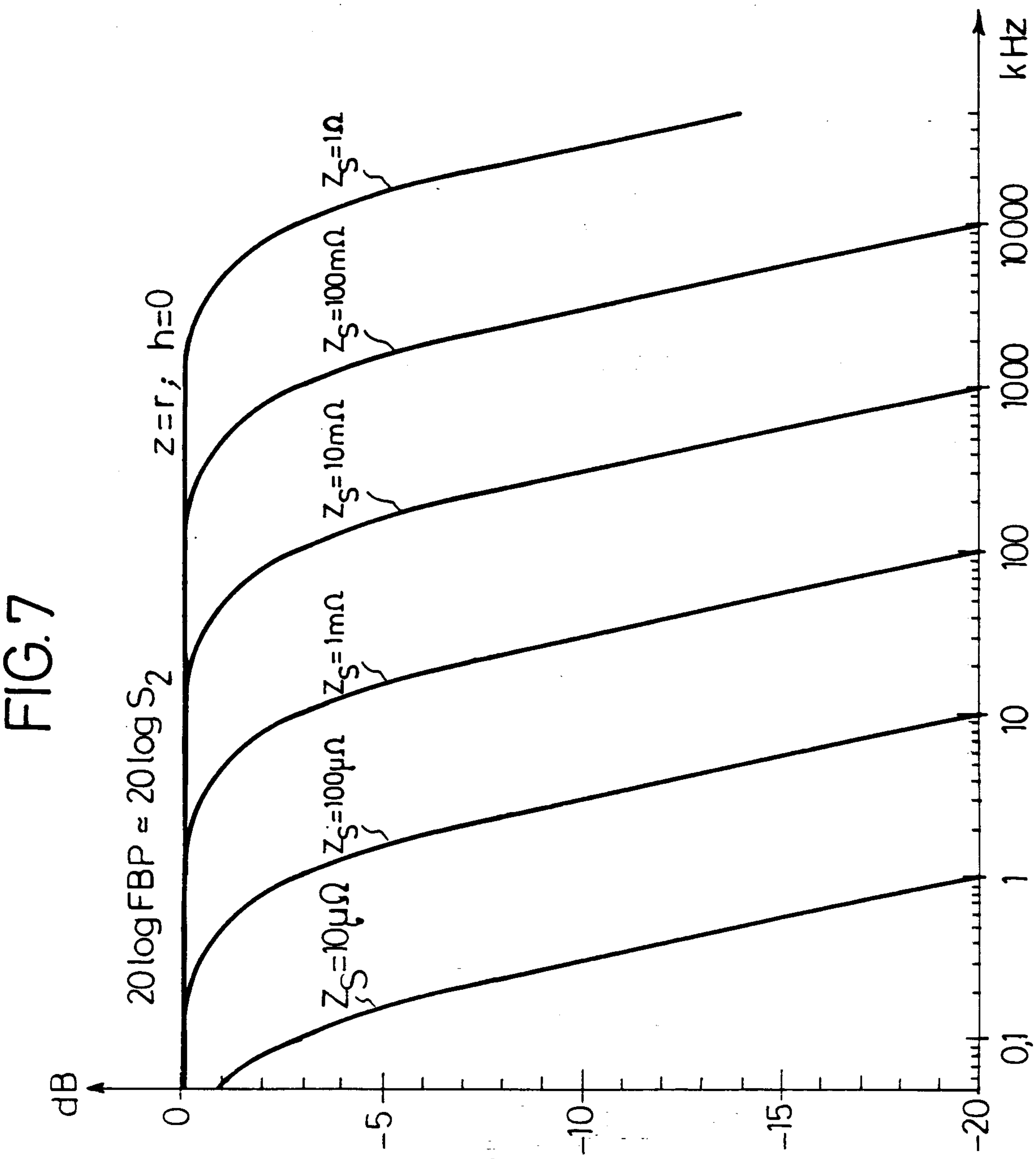
dB
0
-5
-10
-15
-20
0,1
1
10
100
1000
10000
kHz
20 log FBP ≈ 20 log S2
z = r ; h=0
Zs=10μΩ
Zs=100μΩ
Zs=1mΩ
Zs=10mΩ
Zs=100mΩ
Zs=1Ω

FIG. 8

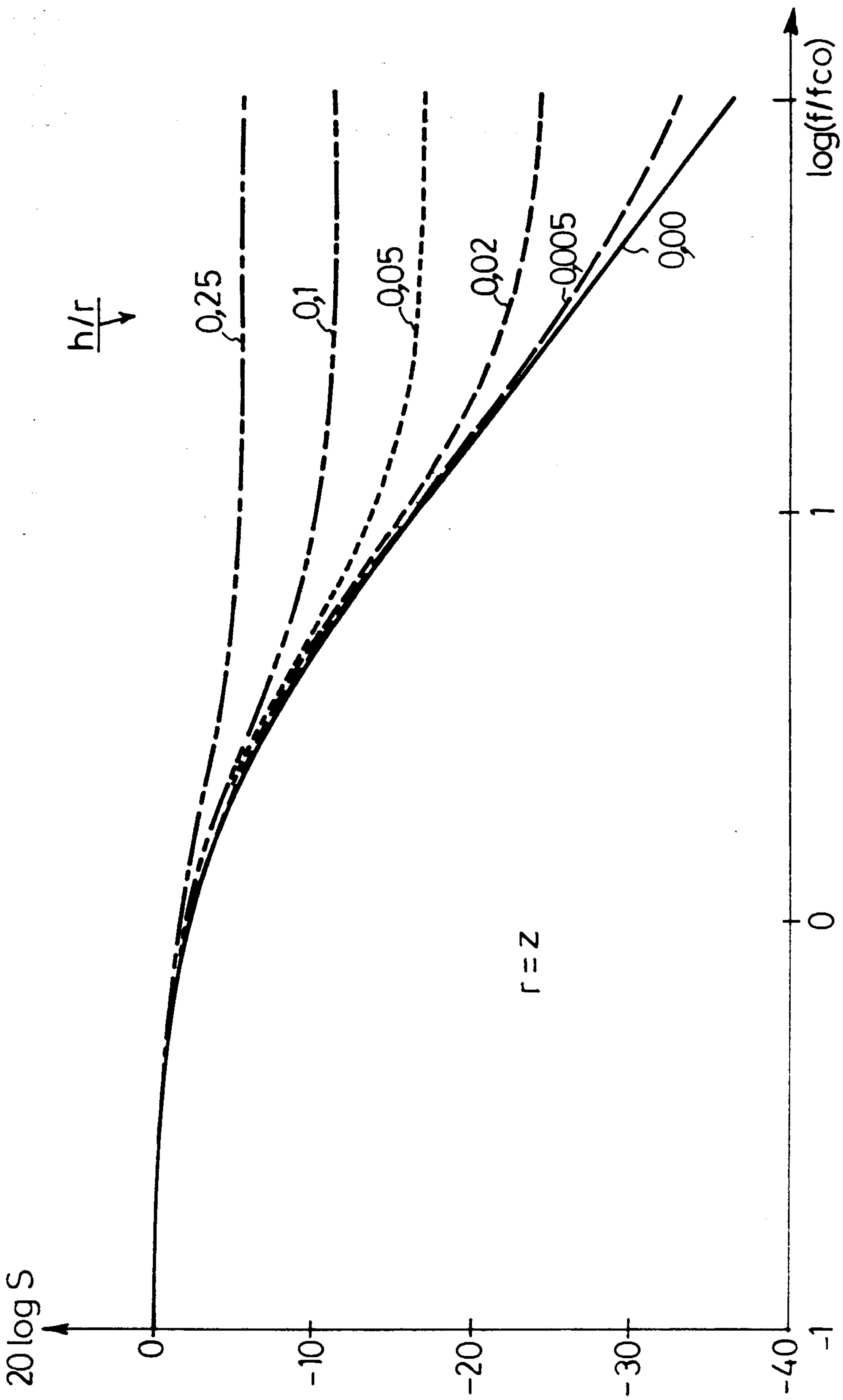

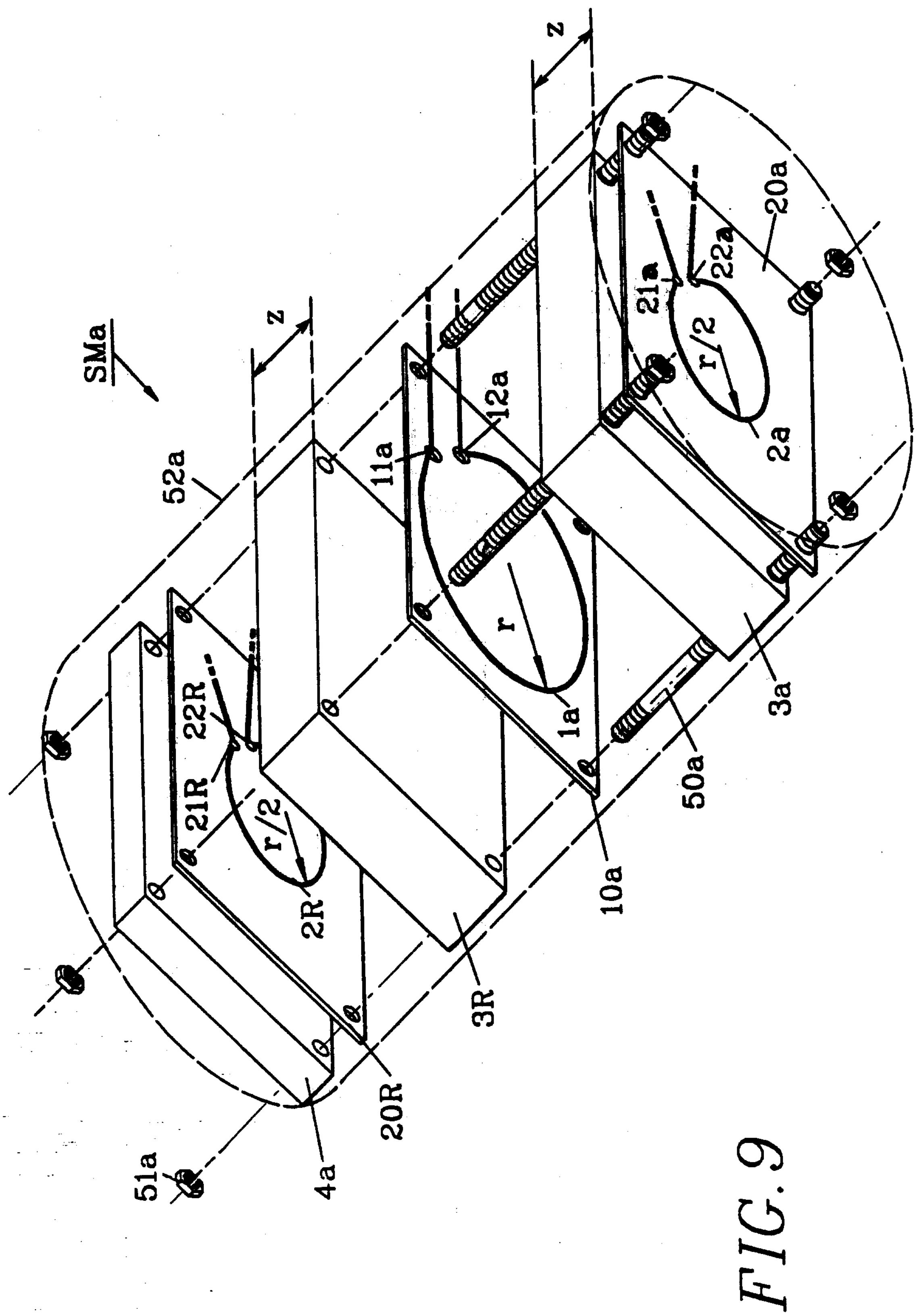
SMa
52a
z
z
11a
12a
21a
22a
20a
r/2
2a
r
1a
3a
50a
10a
22R
21R
r/2
2R
3R
20R
4a
51a

FIG. 9

FIG. 10

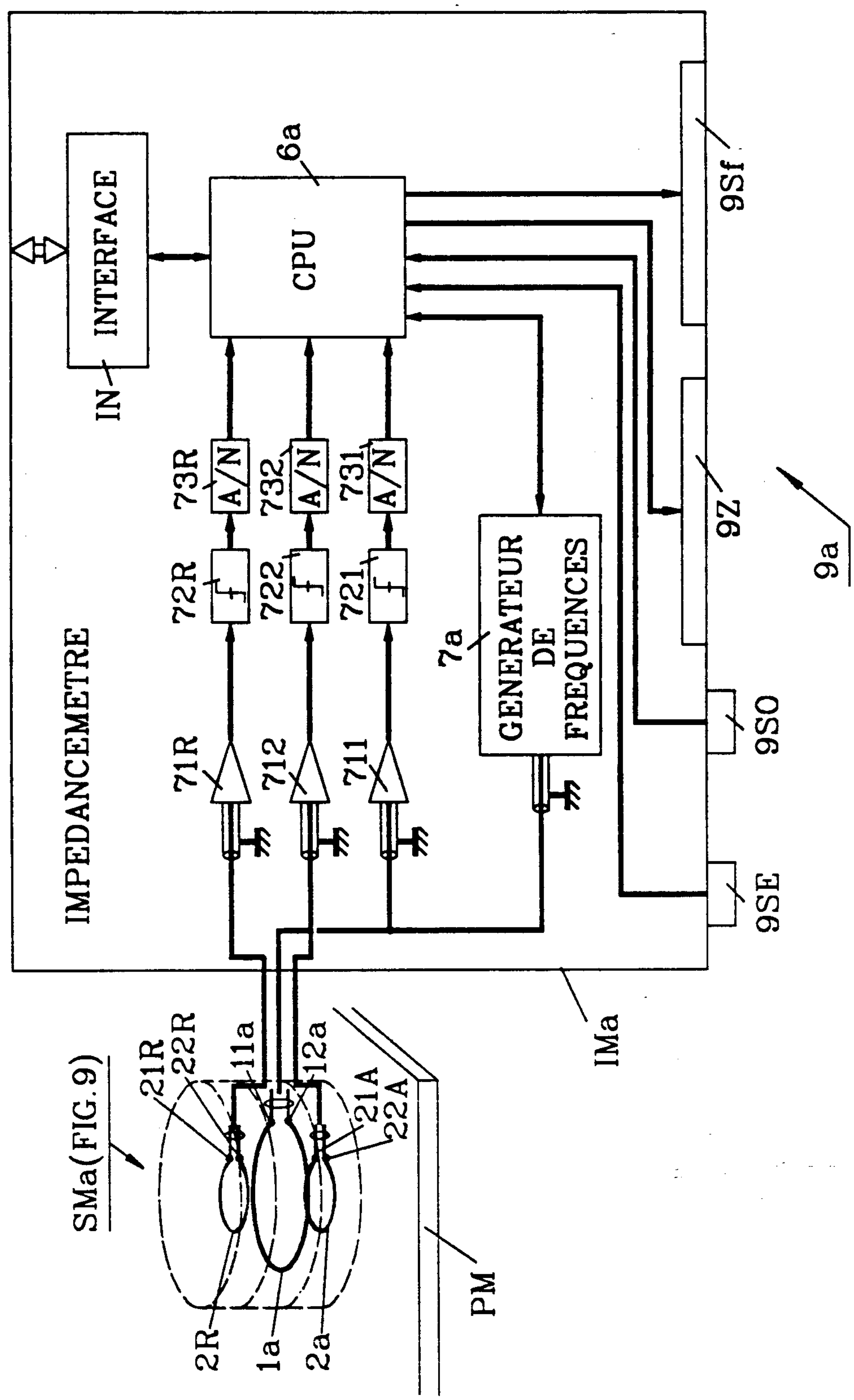
IMPEDANCEMETRE
INTERFACE
IN
CPU
6a
73R
A/N
732
731
72R
722
721
71R
712
711
7a
GENERATEUR
DE
FREQUENCES
9Sf
9Z
9SO
9SE
9a
IMa
SMa(FIG.9)
21R
22R
11a
12a
21A
22A
2R
1a
2a
PM

FIG.11

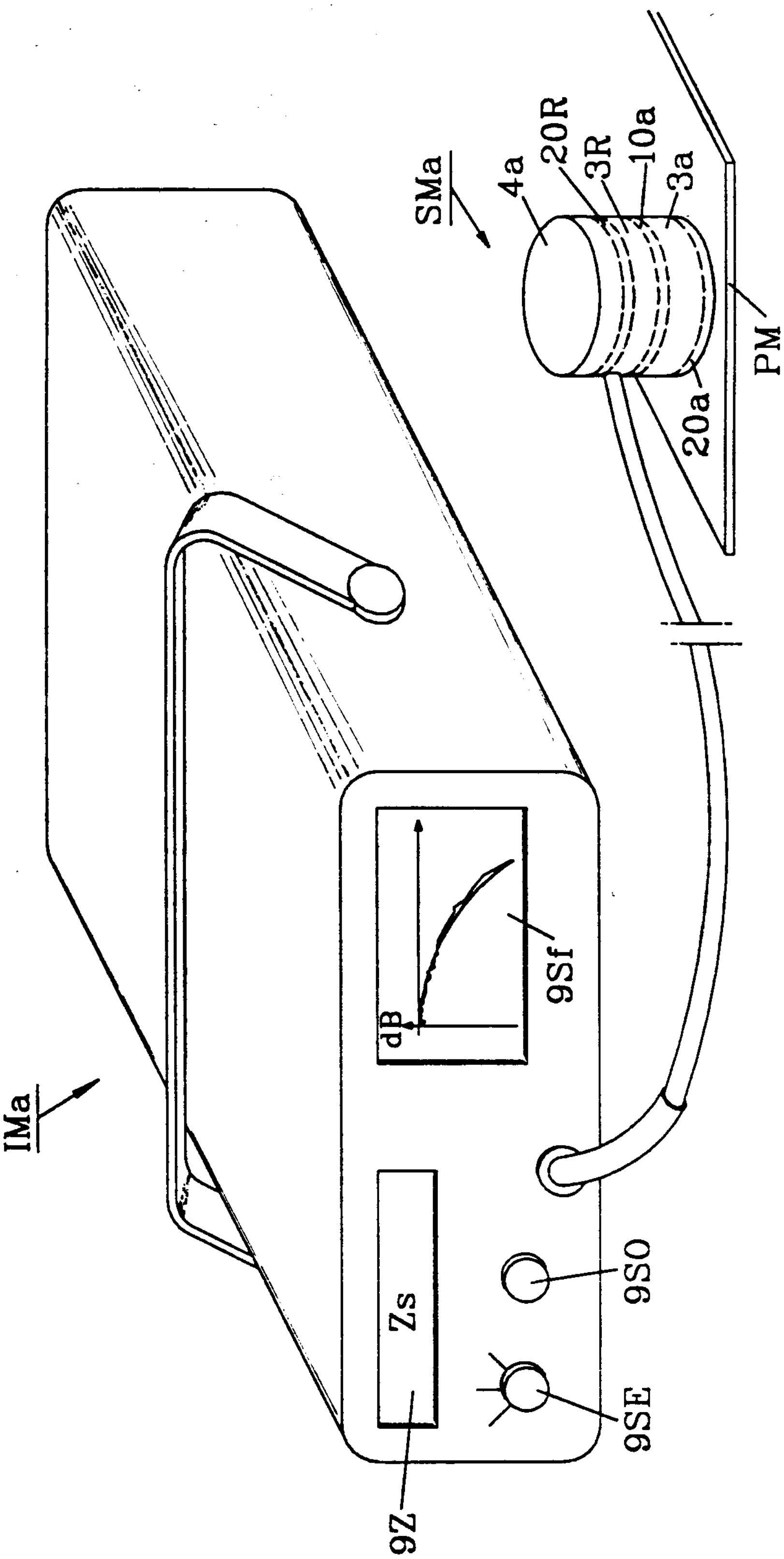

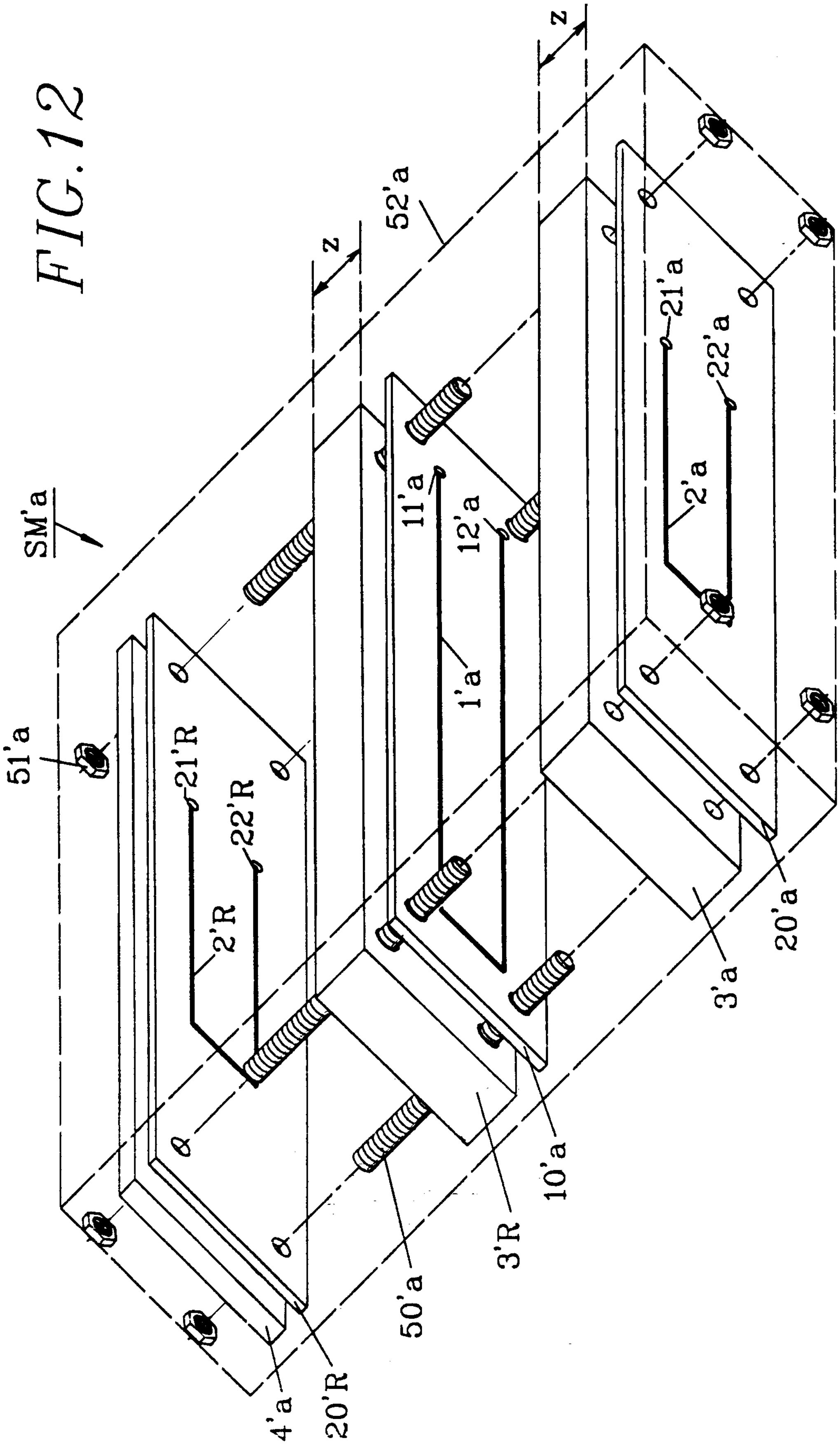
SM'a
51'a
52'a
z
z
21'R
22'R
2'R
11'a
12'a
1'a
21'a
22'a
2'a
4'a
20'R
50'a
3'R
10'a
3'a
20'a

FIG.12